# EUROPEAN PATENT APPLICATION

(11) **EP 4 726 954 A1**
(43) Date of publication of application: **15.04.2026**
(21) Application number: 24852194.0
(22) Date of filing: 31.07.2024
(51) Int. Cl.: H02J 7/00, G01R 31/3835, H01M 10/44, H01M 4/58, H01M 4/485, H01M 4/40

(54) **BATTERY CHARGING METHOD AND DEVICE**

(30) Priority: 04.08.2023 KR 20230102247
(71) Applicant: LG Energy Solution, Ltd., Seoul 07335 (KR)
(72) Inventor: NOH, Suk In, Daejeon 34122 (KR); KIM, Ji Hyun, Daejeon 34122 (KR)
(74) Representative: Goddar, Heinz J.
(86) International application number: PCT/KR2024/011286
(87) International publication number: WO 2025/033840

(57) **Abstract**

According to an embodiment disclosed herein, a battery charging method includes measuring a first voltage between a negative electrode of a battery and a reference electrode and a second voltage between a positive electrode of the battery and the reference electrode and charging the battery by applying a voltage to the battery such that the first voltage satisfies a constant value.

## Description

### TECHNICAL FIELD

### CROSS-REFERENCE TO RELATED APPLICATION

This application claims priority to and the benefit of Korean Patent Application No. 10-2023-0102247 filed in the Korean Intellectual Property Office on August 4, 2023, the entire content of which is incorporated herein by reference.

### TECHNICAL FIELD

Embodiments disclosed herein relate to a battery charging method and apparatus.

### BACKGROUND ART

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Generally, a battery charging device charges a battery using a constant current (CC) and/or constant voltage (CV) charging scheme. The CC scheme may refer to supplying CC power up to a preset voltage to a battery to charge the battery. The CV scheme may refer to charging the battery while reducing charging current to maintain a specific voltage.

However, general CC and/or CV charging scheme does not reflect effects from degradation of the battery, such that as the number of times of charging increases, the risk of lithium precipitation may increase and lifetime deterioration may occur. As a result, a conventional charging protocol focuses on prevention of lithium precipitation, resulting in a limitation in shortening a charging time while preventing lithium precipitation.

### DISCLOSURE

### TECHNICAL PROBLEM

Embodiments disclosed herein aim to provide a battery charging method and apparatus having applied thereto a new type of charging scheme capable of securing a charging speed while securing preventing lithium precipitation by including a reference voltage to charge a battery in such a way to apply a specific voltage to a negative electrode.

Technical problems of the embodiments disclosed herein are not limited to the above-described technical problems, and other unmentioned technical problems would be clearly understood by one of ordinary skill in the art from the following description.

### TECHNICAL SOLUTION

According to an embodiment disclosed herein, a battery charging method includes measuring a first voltage between a negative electrode of a battery and a reference electrode and a second voltage between a positive electrode of the battery and the reference electrode and charging the battery by applying a voltage to the battery such that the first voltage satisfies a constant value.

According to an embodiment, the battery charging method may further include controlling charging of the battery to be terminated based on at least one of the second voltage and a charging current.

According to an embodiment, the controlling of charging of the battery to be terminated may include terminating charging of the battery when the second voltage reaches a cut-off voltage or the charging current reaches a cut-off current.

According to an embodiment, the cut-off current may be determined in a range over 1/1000 C and below 1/10 C.

According to an embodiment, the cut-off voltage may be determined according to a type of a positive electrode material included in the positive electrode.

According to an embodiment, the constant value may be determined in a range over 0 V and below 0.1 V.

According to an embodiment, the reference electrode may include an active material of any one of lithium ferrophosphate (LFP), lithium titanate oxide (LTO), Li-Bi, Li-Sn, Li-Au, Li-Al, and Li.

A battery charging apparatus according to an embodiment disclosed herein includes a measurement unit configured to measure a first voltage between a negative electrode of a battery and a reference electrode and a second voltage between a positive electrode of the battery and the reference electrode and a controller configured to control charging of the battery by applying a voltage to the battery such that the first voltage satisfies a constant value.

According to an embodiment, the controller may be further configured to control charging of the battery to be terminated based on at least one of the second voltage and a charging current.

According to an embodiment, the controller may be further configured to terminate charging of the battery when the second voltage reaches a cut-off voltage or the charging current reaches a cut-off current.

### ADVANTAGEOUS EFFECTS

A battery charging method and apparatus according to embodiments disclosed herein may secure a charging speed simultaneously with preventing lithium precipitation.

In addition, various effects identified directly or indirectly through this document may be provided.

### DESCRIPTION OF DRAWINGS

FIG. 1 shows an example of a 3-electrode battery cell according to an embodiment disclosed herein.
FIG. 2 is a block diagram of a battery management apparatus, according to an embodiment disclosed herein.
FIG. 3 shows an example of a voltage change in charging/discharging, according to an embodiment disclosed herein.
FIG. 4 shows an example of a result of applying a charging scheme, according to an embodiment disclosed herein.
FIG. 5 is a flowchart of a battery charging method according to an embodiment disclosed herein.
FIG. 6 is a flowchart for describing a process of terminating battery charging, according to an embodiment disclosed herein

### MODE FOR INVENTION

Hereinafter, various embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

Herein, it is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

Each component (e.g., a module or a program) of the components described herein may include a single entity or multiple entities. According to various embodiments, one or more of the components may be omitted, or one or more other components may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

As used herein, the term "module" or "...unit" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments of the present document may be implemented as software (e.g., a program or application) including one or more instructions that are stored in a storage medium (e.g., a memory) that is readable by a machine. For example, a processor of the machine may invoke at least one of the one or more instructions stored in the storage medium, and execute it, with or without using one or more other components under the control of the processor. This may enable the machine to operate to perform at least one function according to the at least one called instruction. The one or more instructions may include a code generated by a compiler or a code executable by an interpreter. A machine-readable storage medium may be provided in the form of a non-transitory storage medium. Herein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

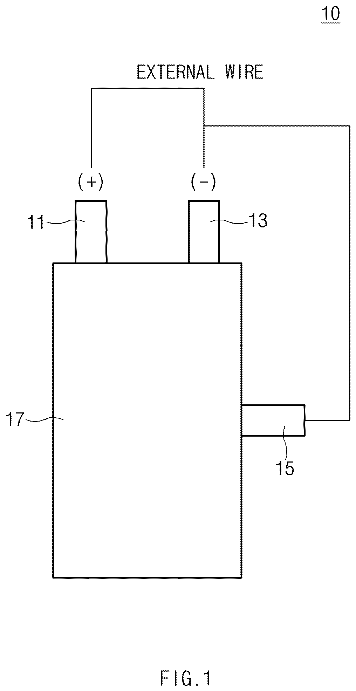

FIG. 1 shows an example of a 3-electrode battery cell according to an embodiment disclosed herein.

Referring to FIG. 1, a battery cell 10 may include a positive electrode 11, a negative electrode 13, a reference electrode 15, and a housing 17. While the battery cell 10 is shown as a pouch-type cell in FIG. 1, the battery cell 10 may have various shapes such as a cylindrical cell, a prismatic cell, etc. The battery cell 10 may be a chargeable secondary battery.

In the battery cell 10, in charging, lithium ions released from lithium atoms of the positive electrode 11 may move to a negative electrode 13 through an electrolyte, and the moved lithium ions may be chemically coupled in the negative electrode 13 and stored in a negative electrode. That is, the lithium ions released from the positive electrode 11 during charging may be reduced to the negative electrode 13.

On the other hand, the lithium atom stored in the negative electrode 13 may be oxidized in discharging of the battery cell 10, such that as an electron moves through an external wire, current may be generated and the lithium ions may move to the positive electrode 11 through the electrolyte. The lithium ions released from the negative electrode 13 may be reduced to the positive electrode 11.

The reference electrode 15 may be configured not to directly contact the positive electrode 11 and the negative electrode 13. The reference electrode 15, which is a control electrode, may be configured such that current does not flow between the reference electrode 15 and the positive electrode 11 and the reference electrode 15 and the negative electrode 13. The housing 17 may include a positive electrode material, a negative electrode material, and a separator that separates them from each other.

When fast charging occurs or the number of times of charging of the battery cell 10 increases, a time required for diffusion of the lithium ions may be insufficient or a voltage lower than a standard lithium Li0/Li+ potential may be applied to the negative electrode 13 due to deterioration of the battery, resulting in lithium precipitation in the negative electrode 13.

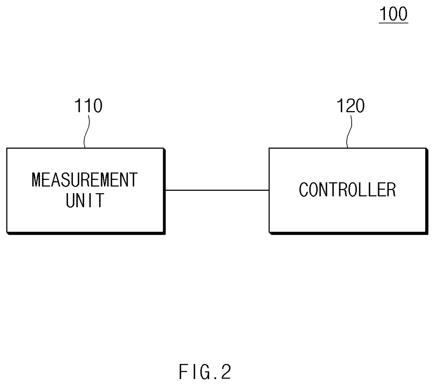

Thus, it is important to set the charging protocol to prevent lithium from being precipitated during charging of the battery cell 10, but for general CC/CV charging, it is difficult to consider a potential change, etc., due to deterioration of the battery cell 10, making it difficult to determine the charging protocol in such a way to prevent lithium precipitation as the number of times of charging increases. In this regard, with reference to FIG. 2, a description will be made of a battery management apparatus and method using a charging scheme capable of preventing lithium precipitation while optimally using a charging time and a discharging capacity in a 3-electrode cell.

FIG. 2 is a block diagram of a battery management apparatus, according to an embodiment disclosed herein.

Referring to FIG. 2, a battery charging apparatus 100 may include a measurement unit 110 and a controller 120.

The battery charging apparatus 100 may charge a battery according to a charging scheme that supplies voltage to the battery such that a negative electrode voltage, i.e., a voltage between a negative electrode and a reference electrode is constant. The battery charging apparatus 100 may charge the battery according to a charging protocol determined in a condition that the anode voltage has a specific value. The charging protocol may be configured with information about a current that charges the battery according to a step based on a time required for charging the battery. For example, the charge protocol may be configured with a C-rate per charge depth of the battery. In this case, C-rate may mean the degree of a current with which a battery cell is charged with respect to a rated capacity.

The battery charging apparatus 100 may prevent lifetime deterioration of the battery from occurring due to lithium precipitation in a charging situation including fast charging by maintaining a negative electrode voltage constant within a range in which lithium precipitation does not occur. In addition, during charging, lithium precipitation may be prevented to solve the risk of fire occurring in lithium precipitation.

According to an embodiment, the battery may be any one of a battery cell, a battery module, and a battery pack. The battery may be a 3-electrode battery cell including a positive electrode, a negative electrode, and a reference electrode. The reference electrode may be positioned between the positive electrode and the negative electrode or an edge of the battery, and the position of the reference electrode is not limited thereto. The reference electrode may not directly contact the positive electrode and the negative electrode. To this end, in the housing of the battery cell, a separate separator for separating the positive electrode and the negative electrode from the reference electrode may be formed.

The measurement unit 110 may measure a voltage of the battery. More specifically, the measurement unit 110 may measure a first voltage between the negative electrode and the reference electrode of the battery and a second voltage between the positive electrode and the reference electrode of the battery. The measurement unit 110 may include a voltage sensor for measuring the first voltage and the second voltage.

For example, when a potential of the positive electrode is x, a potential of the negative electrode is y, and a potential of the reference electrode is z with respect to a standard potential (Li0/Li+)) of lithium, the measurement unit 110 may measure the first voltage as Z - Y and the second voltage as Z - X.

According to an embodiment, the reference electrode may include any one active material among lithium ferrophosphate (LFP), lithium titanate oxide (LTO), Li-Bi, Li-Sn, Li-Au, Li-Al, and Li. These active materials may have standard potentials remaining constant when compared to other materials, and the reference electrode may include any one active material among the materials to have a constant reference potential. In an embodiment, the reference electrode may include any one of the plurality of active materials to more clarify the reference potential, and may not include a mixture of the plurality of active materials.

The measurement unit 110 may more accurately measure the first voltage and the second voltage as the reference potential of the reference electrode is formed constant. Thus, it is possible to solve a problem of inaccurate measured values of the positive electrode and negative electrode voltages in 2-electrode battery cells not including the reference electrode. In addition, the measurement unit 110 may prevent a possibility of the negative electrode voltage being formed in the negative electrode in charging control due to a measurement error by accurately measuring the first voltage and the second voltage, thereby preventing lithium precipitation and may accurately determine a charging end point in time by accurately measuring the second voltage.

The controller 120 may control charging of the battery by applying a voltage to the battery such that the first voltage satisfies a specific value. That is, the controller 120 may control the battery to be charged using a charging scheme of applying the voltage to the battery such that the first voltage is constant, unlike a general CV charging scheme of applying the voltage to the battery such that a voltage between the positive electrode and the negative electrode is constant. In this case, the controller 120 may maintain the first voltage in a charging process of the battery, thereby preventing lithium from being precipitated in the negative electrode. In the positive electrode, a voltage according to C-rate of the charging protocol may be applied.

Using the general CV charging scheme of applying a constant voltage between a positive electrode and a negative electrode, a negative voltage may be formed in a negative potential (a positive potential - a specific voltage) when a positive potential fluctuates. In addition, the general CV charging scheme may not reflect a voltage drop of the positive electrode potential due to breakdown of a battery cell such that the negative electrode voltage may be formed in the negative electrode. On the other hand, a charging scheme according to the present disclosure may maintain the first voltage for the negative electrode as having a constant value for the reference electrode having the reference potential maintained constant, thereby solving the problem of voltage degradation of the positive electrode or the measurement error due to deterioration of the battery cell.

According to an embodiment, the constant value may be determined in a range above 0 V and below 0.1 V. When the first voltage is greater than or equal to the standard potential of lithium, lithium ions delivered to the negative electrode during charging may spread into the electrolyte and/or the negative electrode and thus lithium may not be precipitated. Thus, the battery charging apparatus 100 may determine the constant value as a value exceeding 0 V such that lithium is not precipitated.

When the constant value is higher than a predetermined level, the battery charging apparatus 100 may determine an upper limit of the constant value because there is a possibility of incomplete charging due to arrival of the second voltage at the upper limit, etc. The upper limit may be experimentally or statistically determined and may be, for example, 0.1 V.

According to an embodiment, the controller 120 may control charging termination of the battery based on at least one of the second voltage and charging current. For example, the controller 120 may determine charging completion of the battery based on the second voltage and/or the charging current, and control charging to be terminated when determining that charging of the battery is completed.

According to an embodiment, the controller 120 may control charging to be terminated when the second voltage reaches a cut-off voltage and/or the charging current reaches a cut-off current. As charging of the battery cell progresses, the amount of charging of the battery increases, such that the positive electrode voltage may increase. Thus, when the second voltage reaches the cut-off voltage, the controller 120 may determine that charging is completed and control charging to be terminated.

In an embodiment, the controller 120 may reduce the C-rate of the charging current as charging progresses because the amount of lithium in the negative electrode increases as charging progresses. In this case, the charging current decreases as charging is completed, such that the controller 120 may determine charging to be completed and control charging to be terminated when the charging current decreases and reaches the cut-off current.

The cut-off voltage and the cut-off current may be experimentally and statistically determined in advance, and may be set based on the second voltage and the charging current at a point in time of completion of charging of the battery cell. Herein, the point in time of completion of charging may mean a point in time at which an SOC of the battery cell reaches a reference value (e.g., 100 %).

According to an embodiment, the cut-off current may be determined in a range above 1/1000 C (Coulomb) and below 1/10C. The cut-off current may be determined differently according to a type of a battery that is a charging target, a size of the battery, a type of the positive electrode material, a type of the negative electrode material, a use period, the number of times of charging, etc.

According to an embodiment, the cut-off voltage may be determined according to the type of the positive electrode material included in the positive electrode. The positive electrode of the battery may include various positive electrode materials such as lithium cobalt oxide (LCO), lithium manganese oxide (LMO), LFP, etc., and the reference potential may change according to the type of the positive electrode material and thus the cut-off voltage may change according to the type of the positive electrode material.

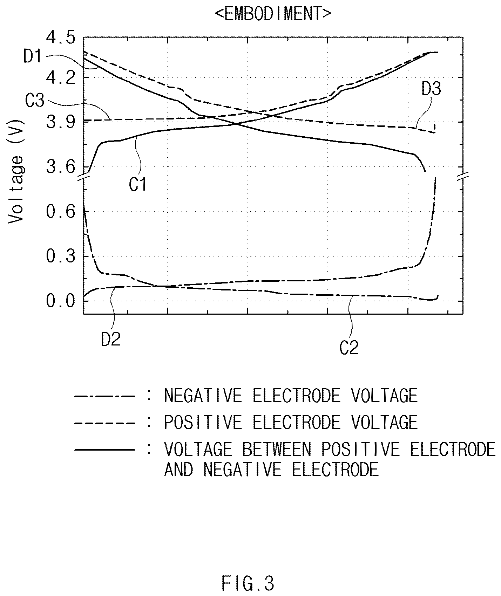

FIG. 3 shows an example of a voltage change in charging/discharging, according to an embodiment disclosed herein.

In FIG. 3, an x-axis indicates time, a y-axis indicates a voltage, and C1, C2, and C3 are graphs respectively indicating a voltage change, a change of a negative electrode voltage, and a change of a positive electrode voltage of the battery in charging. Herein, the voltage of the battery may refer to a potential between the positive electrode and the negative electrode, the negative electrode voltage may refer to a potential between the negative electrode and the reference electrode, and the positive electrode voltage may refer to a potential between the positive electrode and the reference electrode. Likewise, D1, D2, and D3 are graphs respectively indicating a voltage change, a change of a negative electrode voltage, and a change of a positive electrode voltage of the battery in discharging.

Referring to C1 of FIG. 3, it may be seen that when the battery is charged using a charging scheme according to an embodiment disclosed herein, the negative voltage is not formed in the negative electrode even elapse of a charging time. As such, when the charging scheme according to the present disclosure is applied, lithium precipitation in the negative electrode may be prevented and thus the lifetime reduction of the battery may be prevented.

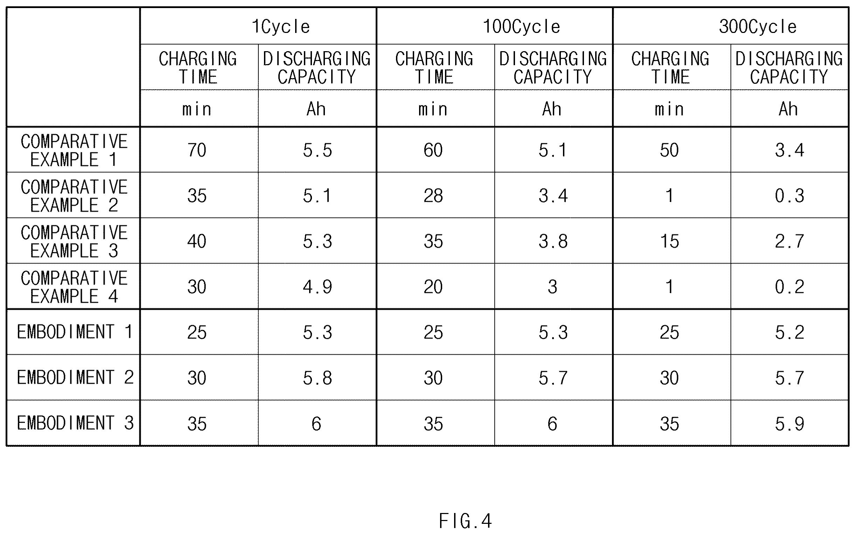

FIG. 4 shows an example of a result of applying a charging scheme, according to an embodiment disclosed herein.

Referring to FIG. 4, a result of comparing battery performance and charging time according to a charging scheme of a battery cell may be seen. In FIG. 4, an experiment condition of each example is as shown in the table below.

**[Table 1]**

| | Charging Scheme | Charging Protocol | cut-off Condition |
|---|---|---|---|
| Comparati ve Example 1 | CC + CV Charging | 1.0 CC Charging -> 4.3 V CV Charging | cut-off Current 1/20C |
| Comparati ve Example 2 | CC + CV Charging | 2.0 CC Charging -> 4.3 V CV Charging | cut-off Current 1/20C |
| Comparati ve Example 3 | Step CC + CV Charging | 2.0 C CC Charging ~ 4.0 V -> 1.5 C CC Charging ~ 4.1 V -> 1.0 CC Charging ~ 4.3 V -> 4.3 V CV Charging | cut-off Current 1/20C |
| Comparati ve Example 4 | Step CC + CV Charging | 3.0 C CC Charging ~ 4.0 V -> 2.0 C CC Charging ~ 4.1 V -> 1.0 CC Charging ~ 4.3 V -> 4.3 V CV Charging | cut-off Current 1/20C |
| Embodime nt 1 | Negative Electrode CV Charging | Negative Electrode Voltage 0.1 V CV Charging | cut-off Current 1/20 C or Positive Electrode cut-off Voltage 4.35 V |
| Embodime nt 2 | Negative Electrode CV Charging | Negative Electrode Voltage 0.05 V CV Charging | cut-off Current 1/20 C or Positive Electrode cut-off Voltage 4.35 V |
| Embodime nt 3 | Negative Electrode CV Charging | Negative Electrode Voltage 0.03 V CV Charging | cut-off Current 1/20 C or Positive Electrode cut-off Voltage 4.35 V |

Referring to Table 1 and FIG. 4, it may be seen that when charging is performed using a negative electrode CV charging scheme such that a negative electrode voltage satisfies a constant value, according to the present disclosure, a charging time may be shortened and a charging capacity may be maintained in spite of increase in the number of times of charging (cycle), when compared to a CC+CV charging scheme and a step CC+CV charging scheme. Negative electrode CV charging may refer to a charging scheme according to an embodiment disclosed herein in which a voltage is applied to the battery such that the first voltage satisfies a constant value.

Herein, the CC+CV charging scheme may refer to a charging scheme that performs charging with a constant current and, when a battery voltage (a voltage between the positive electrode and the negative electrode) reaches the reference voltage, then perform CV charging. For example, in Comparative Example 1, when a battery voltage is less than or equal to a reference voltage of 4.3 V, the battery is charged with a CC with a C-rate of 1.0 and, when the battery voltage reaches the reference voltage of 4.3 V, the battery may be charged with a CV of 4.3 V that is the reference voltage.

In the step CC+CV charging scheme, step CC charging may refer to a scheme that charges the battery while stepwisely reducing the C-rate of the charging current by considering the possibility of lithium precipitation due to increase in the amount of lithium of the negative electrode as step CC charging progresses. For example, in Comparative Example 3, when the battery is charged with a CC at a C-rate of 2.0 and the battery voltage reaches 4.0 V, then charging may be switched to CC charging at a C-rate of 1.5, and when the battery voltage reaches 4.1 V, CC charging may be performed at a C-rate of 1.0. Thereafter, when the battery voltage reaches a reference voltage of 4.3 V, then CV charging may be performed.

As the number of times of charging (cycle) of the battery increases, it may be seen in Comparative Example 2 and Comparative Example 4 that a charging time is abnormally shortened as a discharging capacity retention rate of the battery sharply decreases. This may mean that the life of the battery rapidly deteriorates due to lithium precipitation of the battery and thus the battery cell may not operate normally. It may be seen from results of Comparative Example 1 and Example 3 that a discharging capacity of a battery cell significantly decreases from a discharging capacity of initial charging (1 cycle) and thus deterioration of the battery significantly progresses.

On the other hand, when the battery is charged using a charging scheme (negative electrode CV charging) according to the present disclosure, a negative voltage is not formed in the negative electrode voltage, thereby preventing lithium precipitation and thus maintaining the discharging capacity almost constantly even when the number of times of charging reaches 300 cycles. That is, by using the charging scheme according to the present disclosure, a charging time may be shortened and lithium precipitation may be prevented, thereby preventing rapid life degradation of the battery cell.

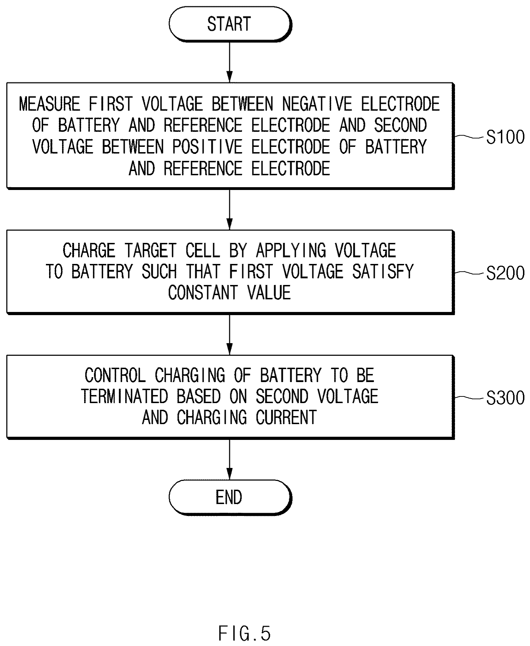

FIG. 5 is a flowchart of a battery charging method according to an embodiment disclosed herein.

Referring to FIG. 5, a battery charging method may include operation S100 of measuring a first voltage between a negative electrode of a battery and a reference electrode and a second voltage between a positive electrode of the battery and the reference electrode, operation S200 of charging a target cell by applying a voltage to the battery such that the first voltage satisfies a constant value, and operation S300 of controlling charging of the battery to be terminated, based on at least one of the second voltage and a charging current.

In operation S100, the measurement unit 110 may measure the first voltage and the second voltage. The measurement unit 110 may include a voltage sensor for measuring the first voltage and the second voltage.

In operation S200, the controller 120 may apply the voltage to the battery such that the first voltage satisfies the constant value. The controller 120 may prevent lithium precipitation from occurring due to a negative voltage being formed in the negative electrode as the first voltage satisfies the constant value.

In operation S300, the controller 120 may control charging termination of the battery based on at least one of the second voltage and charging current. The measurement unit 110 may measure the charging current of the battery and include a current sensor for measuring the charging current. In an embodiment, the controller 120 may control charging to be terminated when the second voltage reaches a cut-off voltage and/or the charging current reaches a cut-off current.

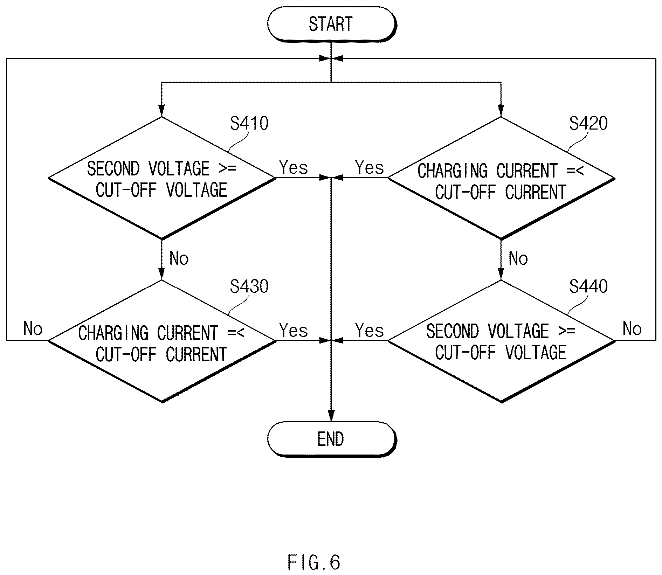

FIG. 6 is a flowchart for describing a process of terminating battery charging, according to an embodiment disclosed herein.

Referring to FIG. 6, the battery charging apparatus 100 may control charging of the battery to be terminated based on at least one of the charging current and the second voltage of the battery. The controller 120 may determine whether a state of the battery satisfies a specific condition after charging of the battery starts.

In operation S410, the controller 120 may determine whether the second voltage of the battery is greater than or equal to the cut-off voltage. When the second voltage of the battery is the same as the cut-off voltage, the controller 120 may determine that the second voltage reaches the cut-off voltage. The controller 120 may control charging to be terminated when the second voltage is greater than or equal to the cut-off voltage (Yes in operation S410). The controller 120 may go to operation S430 when the second voltage is less than the cut-off voltage (No in operation S410).

In operation S420, the controller 120 may determine whether the charging current of the battery is less than or equal to the cut-off current. When the charging current of the battery is the same as the cut-off current, the controller 120 may determine that the charging current reaches the cut-off current. The controller 120 may control charging to be terminated when the charging current is less than or equal to the cut-off current (Yes in operation S420). The controller 120 may go to operation S440 when the charging current exceeds the cut-off current (No in operation S420).

In operation S420, the controller 120 may determine whether the charging current of the battery is less than or equal to the cut-off current. The controller 120 may control charging to be terminated when the charging current is less than or equal to the cut-off current (Yes in operation S430). The controller 120 may continue charging when the charging current exceeds the cut-off current (No in operation S430).

In operation S420, the controller 120 may determine whether the second voltage of the battery is greater than or equal to the cut-off voltage. The controller 120 may control charging to be terminated when the second voltage is greater than or equal to the cut-off voltage (Yes in operation S440). The controller 120 may continue charging when the second voltage is less than the cut-off voltage (No in operation S440).

Even though all components constituting an embodiment disclosed herein have been described above as being combined into one or operating in combination, the embodiments disclosed herein are not necessarily limited to the embodiment. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The above description is merely illustrative of the technical idea disclosed herein, and various modifications and variations will be possible without departing from the essential characteristics of the embodiments disclosed herein by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of this document.

### [EXPLANATION OF REFERENCE NUMERALS DESIGNATING THE MAJOR ELEMENTS OF THE DRAWINGS]

10: BATTERY CELL
11: POSITIVE ELECTRODE
13: NEGATIVE ELECTRODE
15: REFERENCE ELECTRODE
17: HOUSING
100: BATTERY CHARGING APPARATUS
110: MEASUREMENT UNIT
120: CONTROLLER

## Claims

1. A battery charging method comprising:
measuring a first voltage between a negative electrode of a battery and a reference electrode and a second voltage between a positive electrode of the battery and the reference electrode; and
charging the battery by applying a voltage to the battery such that the first voltage satisfies a constant value.

2. The battery charging method of claim 1, further comprising controlling charging of the battery to be terminated based on at least one of the second voltage and a charging current.

3. The battery charging method of claim 2, wherein the controlling of charging of the battery to be terminated comprises terminating charging of the battery when the second voltage reaches a cut-off voltage or the charging current reaches a cut-off current.

4. The battery charging method of claim 3, wherein the cut-off current is determined in a range over 1/1000 C and below 1/10 C.

5. The battery charging method of claim 3, wherein the cut-off voltage is determined according to a type of a positive electrode material included in the positive electrode.

6. The battery charging method of claim 1, wherein the constant value is determined in a range over 0 V and below 0.1 V.

7. The battery charging method of claim 1, wherein the reference electrode comprises an active material of any one of lithium ferrophosphate (LFP), lithium titanate oxide (LTO), Li-Bi, Li-Sn, Li-Au, Li-Al, and Li.

8. A battery charging apparatus comprising:
a measurement unit configured to measure a first voltage between a negative electrode of a battery and a reference electrode and a second voltage between a positive electrode of the battery and the reference electrode; and
a controller configured to control charging of the battery by applying a voltage to the battery such that the first voltage satisfies a constant value.

9. The battery charging apparatus of claim 8, wherein the controller is further configured to control charging of the battery to be terminated based on at least one of the second voltage and a charging current.

10. The battery charging apparatus of claim 9, wherein the controller is further configured to terminate charging of the battery when the second voltage reaches a cut-off voltage or the charging current reaches a cut-off current.
